# EUROPEAN PATENT APPLICATION

(11) **EP 4 190 937 A1**
(43) Date of publication of application: **07.06.2023**
(21) Application number: 21895094.7
(22) Date of filing: 17.11.2021
(51) Int. Cl.: C23C 14/24, C23C 14/54, H01L 51/56, H01L 51/00, C23C 14/12

(54) **DEPOSITION APPARATUS FOR ORGANIC LIGHT-EMITTING DIODE**

(30) Priority: 18.11.2020 KR 20200154758
(71) Applicant: Lg Chem, Ltd., Seoul 07336 (KR)
(72) Inventor: JEONG, Kwang Jin, Daejeon 34122 (KR); SHIN, Heeyoung, Daejeon 34122 (KR); KIM, Jae Il, Daejeon 34122 (KR); LEE, Jun Young, Daejeon 34122 (KR)
(74) Representative: Hoffmann Eitle
(86) International application number: PCT/KR2021/016862
(87) International publication number: WO 2022/108326

(57) **Abstract**

The present disclosure relates to a deposition apparatus for an organic light emitting diode, and in particular, to a deposition apparatus for an organic light emitting diode shortening a time of evaluation on a deposition material by independently mainting the deposition material through an auxiliary chamber.

## Description

### [Technical Field]

This application claims priority to and the benefits of Korean Patent Application No. 10-2020-0154758, filed with the Korean Intellectual Property Office on November 18, 2020, the entire contents of which are incorporated herein by reference.

The present disclosure relates to a deposition apparatus for an organic light emitting diode, and in particular, to a deposition apparatus for an organic light emitting diode shortening a time of evaluation on a deposition material by independently mainting the deposition material through an auxiliary chamber.

### [Background Art]

An organic light emitting diode (OLED) is an active light emitting device in which an organic film is provided between two electrodes separated upward and downward, and, when a current flows through the two electrodes, electrons and holes supplied from the two electrodes bind in the organic film to generate light. Such an OLED is thin and light and has properties of high luminance, low power consumption and the like, and is used in various fields. Particularly, an OLED has received attention as a next generation display, and may also be used as an illumination emitting white light and monochromatic light.

In manufacturing an OLED, a process of forming an organic thin film and a process of forming a conductor thin film are required, and as such thin film forming processes, an evaporation deposition is mainly used.

An organic thin film is mostly made in a manner such that a crucible holding a low molecular organic material is heated by flowing a current to a heating wire surrounding the crucible, the heat transferred to the crucible increases a temperature of the organic material in the crucible, and, as the temperature of the organic material increases, the organic material exits the crucible in a gas form and deposited on a substrate. In such manufacturing of organic thin film using a thermal deposition method, an OLED deposition device has been used.

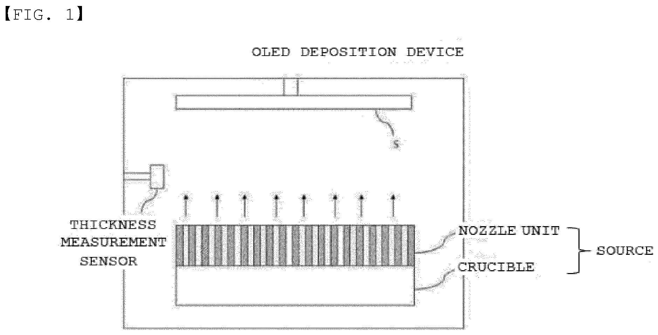

FIG. 1 is a cross-sectional view illustrating an existing OLED deposition device.

When referring to FIG. 1, an existing OLED deposition device has a substrate (S) positioned on the upper portion, and on the lower portion, an OLED deposition device source for heating and evaporating a raw material to deposit the raw material on the substrate (S) and a thickness measurement sensor for measuring a thickness of the thin film deposited on the substrate are provided.

The OLED deposition device source is formed with a crucible accommodating an organic material, a raw material, therein, a heating means wound around the crucible to electrically heat the crucible, and a nozzle unit including a plurality of nozzles provided with a spray hole spraying the raw material evaporated from the crucible by the heating means.

The existing OLED deposition device includes all deposition materials in one reaction chamber, and therefore, whenever an evaporation source is replaced, a vacuum state in the chamber is vented, a new evaporation material is placed, and inside the chamber is made to be in a vacuum state again to conduct a dummy process, which causes a problem in that the time of deposition and the time of evaluation take long.

Accordingly, there have been needs for improving a deposition apparatus for an organic light emitting diode capable of evaluating some of all deposition materials or shortening a time of deposition.

### [Disclosure]

### [Technical Problem]

The present disclosure has been made in view of the above, and the present disclosure is directed to providing a deposition apparatus for an organic light emitting diode shortening a time of evaluation on a deposition material when partially depositing the deposition material by including a plurality of auxiliary chambers including the deposition material and capable of independently conducting maint.

### [Technical Solution]

A deposition apparatus for an organic light emitting diode according to one embodiment of the present disclosure includes a main chamber depositing and evaluating a material; an auxiliary chamber connected to the main chamber and into which a deposition material to deposit is loaded; and a heating unit heating the deposition material loaded into the auxiliary chamber.

In one embodiment, a bellows connecting the auxiliary chamber and the heating unit is included.

In one embodiment, the auxiliary chamber includes a load unit loading the deposition material into a cell of the main chamber.

In one embodiment, the load unit further includes a gate valve controlling movement of the deposition material.

In one embodiment, a vacuum unit making inside the auxiliary chamber be in a vacuum state is further included.

In one embodiment, the auxiliary chamber is placed under the main chamber.

In one embodiment, the auxiliary chamber includes an opening/closing unit on one side for loading and unloading the deposition material.

In one embodiment, the opening/closing unit further includes a compression member for maintaining an atmosphere inside the auxiliary chamber.

In one embodiment, the auxiliary chamber and the heating unit are movable.

In one embodiment, a motor compressing and decompressing the bellows is further included.

### [Advantageous Effects]

According to the present disclosure, an effect of shortening a time of evaluation on a deposition material is obtained when partially depositing the deposition material by including a plurality of auxiliary chambers including the deposition material and capable of independently conducting maint.

### [Description of Drawings]

FIG. 1 is a cross-sectional view illustrating an existing OLED deposition device.
FIG. 2 is a perspective view illustrating a deposition apparatus for an organic light emitting diode according to one embodiment of the present disclosure.
FIG. 3 is an enlarged perspective view of the part A of FIG. 2.
FIG. 4(a) is a cross-sectional view illustrating an auxiliary chamber, a heating unit and a bellows before operating the heating unit, and FIG. 4(b) is a cross-sectional view illustrating the auxiliary chamber and the heating unit when operating the heating unit.

### [Reference Numeral]

100: Deposition Apparatus for Organic Light Emitting Diode
10: Main Chamber
20: Auxiliary Chamber
21: Load Unit
21a: Second Level of Load Unit
21b: First Level of Load Unit
22: Gate Valve
23: Opening/Closing Unit
24: Vacuum Unit
25: Vacuum Valve
30: Heating Unit
40: Bellows

### [Mode for Disclosure]

Detailed descriptions on the present disclosure are to fully describe the present disclosure to those skilled in the art. Throughout the specification, a description of a certain part "including" a certain constituent or being "characterized" by certain structure and shape does not exclude other constituents or exclude other structures and shapes and unless particularly stated on the contrary, and means capable of including other constituents, structures and shapes.

The present disclosure may be diversely modified and may have various embodiments, and therefore, specific embodiments will be provided and described in detail in the detailed descriptions. However, this is not for limiting the contents of the present disclosure by the embodiments, and needs to be construed as including all modifications, equivalents and substitutes included in the ideas and the technical scope of the present disclosure.

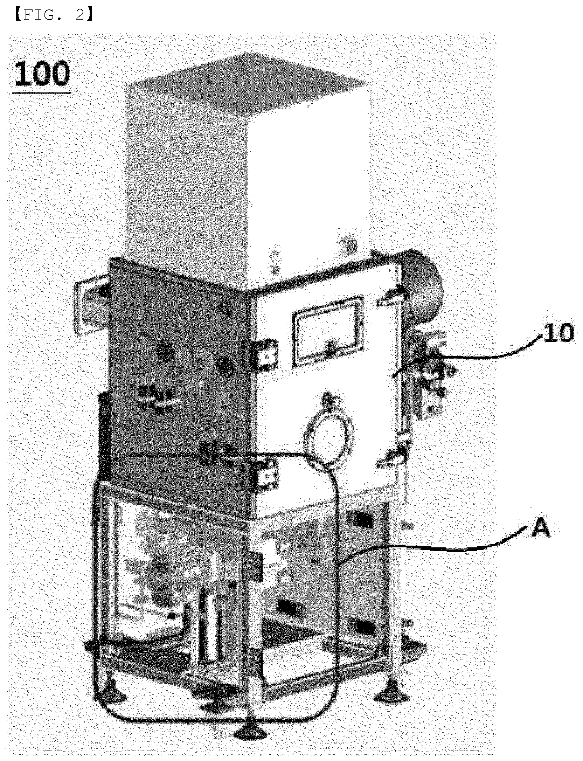

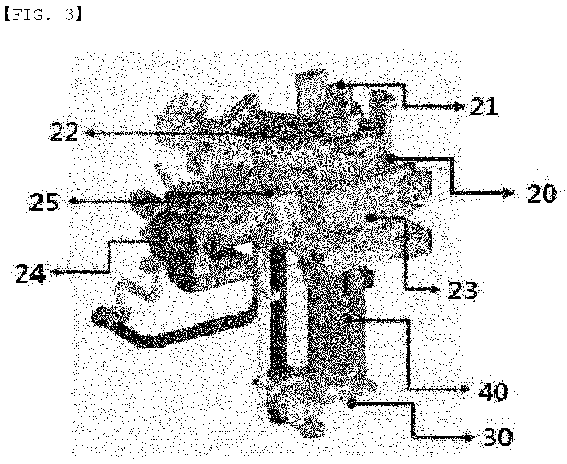

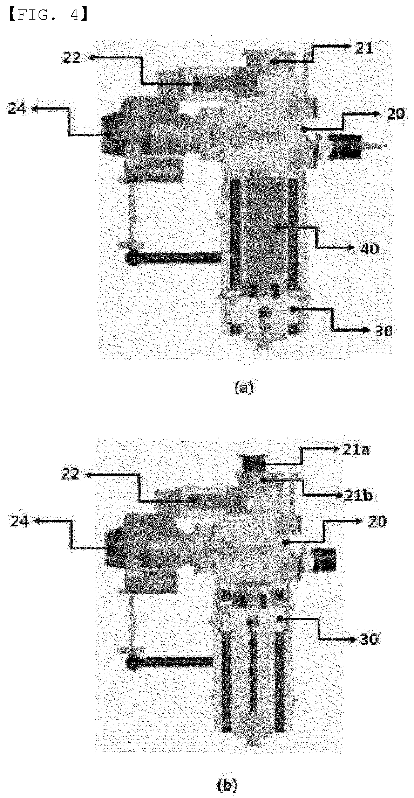

FIG. 2 is a perspective view illustrating a deposition apparatus (100) for an organic light emitting diode according to one embodiment of the present disclosure, FIG. 3 is an enlarged perspective view of the part A of FIG. 2, FIG. 4(a) is a cross-sectional view illustrating an auxiliary chamber (20), a heating unit (30) and a bellows (40) before operating the heating unit, and FIG. 4(b) is a cross-sectional view illustrating the auxiliary chamber (20) and the heating unit (30) when operating the heating unit (30).

The deposition apparatus (100) for an organic light emitting diode according to the present disclosure includes a main chamber (10) and a deposition source (A). Herein, the deposition source (A) includes an auxiliary chamber (20), a heating unit (30) and a bellows (40), and a deposition material is independently separated.

The main chamber (10) is a constitution of depositing a deposition material on a substrate, and may include a substrate support on which a substrate is placed. The main chamber (10) is preferably provided having the inside to be in an atmosphere of vacuum state in order to deposit a deposition material on a substrate. Accordingly, the main chamber (10) may separately manage a vacuum atmosphere by a vacuum/atmospheric pressure control valve.

The main chamber (10) may include a plurality of cells (not shown). The cell may be connected to a load unit (21) of the auxiliary chamber (20) and load a deposition material into the main chamber (10).

The auxiliary chamber (20) is a constitution of being connected to the main chamber (10) and loading a deposition material to deposit. Accordingly, a container into which the deposition material is loaded may be included in the auxiliary chamber (20), and the auxiliary chamber (20) may be placed under the main chamber (10).

The auxiliary chamber (20) may independently conduct maint in order to load the deposition material into the cell of the main chamber (10). In other words, the deposition apparatus (100) for an organic light emitting diode according to the present disclosure is capable of independently mainting one deposition material by the auxiliary chamber (20). Herein, the maint is a process for conducting a dummy process, and means venting a vacuum state of the auxiliary chamber (20), then placing an evaporation material, creating inside the auxiliary chamber (20) to be in a vacuum state again, and then conducting a dummy process. The dummy process means heating the auxiliary chamber (20) to remove impurities inside the auxiliary chamber (20), stabilize the degree of vacuum and vaporize a deposition material.

Accordingly, the auxiliary chamber (20) may include a load unit (21, LTC) in order to load the deposition material into the cell of the main chamber (10). The load unit (21) is a constitution of connecting the auxiliary chamber (20) and the main chamber (10), and may be placed above the auxiliary chamber (20). In other words, the load unit (21) may bind to the cell of the main chamber (10) and load the deposition material into the main chamber (10).

In one embodiment, the load unit (21) may be provided in two levels. Herein, when a part inserted to the inside is the second level (21a) of the two levels in the load unit (21), only the first level (21b) may be provided in the load unit (21) when the main chamber (10) and the auxiliary chamber (20) are not connected. By the second level (21a) protruding and being inserted to the cell of the main chamber (10) when conducting the dummy process, the load unit (21) may connect the main chamber (10) and the auxiliary chamber (20).

The auxiliary chamber (20) may further include a gate valve (22) for controlling the deposition material moved through the load unit (21). In addition, the gate valve (22) may separate the atmosphere inside the auxiliary chamber (20) and the atmosphere inside the main chamber (10).

The gate valve (22) may be placed in the middle of the load unit (21). The gate valve (22) is preferably closed before the load unit (21) is connected to the cell of the main chamber (10).

The auxiliary chamber (20) may further include an opening/closing unit (23) on one side for loading and unloading the deposition material. In other words, the deposition material may enter and exit the auxiliary chamber (20) through the opening/closing unit (23), and the deposition material may be replaced in a container in the auxiliary chamber (20).

In addition, the opening/closing unit (23) may further include a compression member (not shown) in order to maintain the atmosphere inside the auxiliary chamber. The compression member may be placed on a surface where the auxiliary chamber (20) and the opening/closing unit (23) are brought into contact with each other.

After loading the deposition material into the container of the auxiliary chamber (20), the atmosphere formed inside the auxiliary chamber (20) needs to be the same as the atmosphere inside the main chamber (10). Accordingly, the auxiliary chamber (20) may further include a vacuum unit (24) making the inside be in a vacuum state. The deposition apparatus (100) for an organic light emitting diode according to the present disclosure further includes a vacuum valve (25) between the auxiliary chamber (20) and the vacuum unit (24) to maintain the atmosphere inside the auxiliary chamber (20) and control the vacuum unit (24).

The heating unit (30) is a constitution of heating the deposition material loaded into the auxiliary chamber (20). The heating unit (30) heats the auxiliary chamber (20) to a set temperature to stabilize the vacuum atmosphere inside the auxiliary chamber (20), and may vaporize the deposition material.

The heating unit (30) may move up/down to effectively transfer generated heat to the auxiliary chamber (20) or to stop the dummy process.

Herein, the deposition apparatus (100) for an organic light emitting diode according to the present disclosure may further include a bellows (40) connecting the auxiliary chamber (20) and the heating unit (30). The bellows (40) may move the heating unit (30) up/down through compression and tension. Heat generated in the heating unit (30) may be transferred to the auxiliary chamber (20) through the bellows (40).

In one embodiment, in the deposition apparatus (100) for an organic light emitting diode according to the present disclosure, the second level of the load unit (21) may protrude to be connected to the cell of the main chamber (10) when the bellows (40) is compressed and the heating unit (30) moves toward the auxiliary chamber (20). Herein, the load unit (21) may protrude toward the main chamber (10) by the heat heated in the heating unit (30) and the pressure.

In addition, the deposition apparatus (100) for an organic light emitting diode according to the present disclosure may further include a motor (not shown) in order to compress and decompress the bellows (40).

The deposition apparatus (100) for an organic light emitting diode according to the present disclosure may include one or more of the auxiliary chamber (20) and the heating unit (30). For example, when depositing three deposition materials, the three different deposition materials may be each loaded into three auxiliary chambers (20) to conduct the maint.

In another embodiment, the auxiliary chamber (20) and the heating unit (30) are movable. Herein, the deposition apparatus (100) for an organic light emitting diode may further include, under the main chamber (10), a support unit capable of supporting the auxiliary chamber (20) and the heating unit (30), and a rail guiding the moving path, and the auxiliary chamber (20) and the heating unit (30) may move along the position of the cell of the main chamber (10).

The present disclosure has been described with reference to preferred embodiments, however, those skilled in the art may understand that various modifications and changes may be made on the present disclosure within the scope not departing from the ideas and the territory of the present disclosure described in the appended claims.

## Claims

1. A deposition apparatus for an organic light emitting diode, the deposition apparatus comprising:
a main chamber depositing and evaluating a material;
an auxiliary chamber connected to the main chamber and into which a deposition material to deposit is loaded; and
a heating unit heating the deposition material loaded into the auxiliary chamber.

2. The deposition apparatus for an organic light emitting diode of Claim 1, comprising a bellows connecting the auxiliary chamber and the heating unit.

3. The deposition apparatus for an organic light emitting diode of Claim 1, wherein the auxiliary chamber includes a load unit loading the deposition material into a cell of the main chamber.

4. The deposition apparatus for an organic light emitting diode of Claim 3, wherein the load unit further includes a gate valve controlling movement of the deposition material.

5. The deposition apparatus for an organic light emitting diode of Claim 1, further comprising a vacuum unit making inside the auxiliary chamber to be in a vacuum state.

6. The deposition apparatus for an organic light emitting diode of Claim 1, wherein the auxiliary chamber is placed under the main chamber.

7. The deposition apparatus for an organic light emitting diode of Claim 1, wherein the auxiliary chamber includes an opening/closing unit on one side for loading and unloading the deposition material.

8. The deposition apparatus for an organic light emitting diode of Claim 7, wherein the opening/closing unit further includes a compression member for maintaining an atmosphere inside the auxiliary chamber.

9. The deposition apparatus for an organic light emitting diode of Claim 1, wherein the auxiliary chamber and the heating unit are movable.

10. The deposition apparatus for an organic light emitting diode of Claim 2, further comprising a motor compressing and decompressing the bellows.
